# EUROPÄISCHE PATENTSCHRIFT

(11) **EP 2 414 133 B1**
(45) Veröffentlichungstag und Bekanntmachung des Hinweises auf die Patenterteilung: **23.11.2016**
(21) Anmeldenummer: 10712902.5
(22) Anmeldetag: 01.04.2010
(51) Int. Cl.: B24B 7/17, B24B 7/22, B24B 37/04, B24B 49/12

(54) **VERFAHREN ZUM MATERIALABTRAGENDEN BEARBEITEN VON SEHR DÜNNEN WERKSTÜCKEN IN EINER DOPPELSEITENSCHLEIFMASCHINE**
METHOD FOR THE MATERIAL-REMOVING MACHINING OF VERY THIN WORK PIECES IN A DOUBLE SIDE GRINDING MACHINE
PRODÉDÉ D'USINAGE PAR ENLÈVEMENT DE MATIÈRE DE PIÈCES TRÈS MINCES DANS UNE MACHINE DE MEULAGE DOUBLE FACE

(30) Priorität: 01.04.2009 DE 102009015878
(43) Veröffentlichungstag der Anmeldung: 08.02.2012
(73) Patentinhaber: Peter Wolters GmbH, 24768 Rendsburg (DE)
(72) Erfinder: RUNKEL, Frank, 24817 Tetenhusen (DE)
(74) Vertreter: Hauck Patentanwaltspartnerschaft mbB
(86) Internationale Anmeldenummer: PCT/EP2010/002090
(87) Internationale Veröffentlichungsnummer: WO 2010/112225

(56) Entgegenhaltungen:
- EP-A1- 0 534 108
- WO-A1-99/16580
- WO-A1-2009/013231
- DE-A1-102004 063 870
- JP-A- 58 094 964
- JP-A- 62 264 864
- US-A- 5 099 614
- US-A- 5 538 460
- LANDSBERG C ET AL: "Carrier techniques for thin wafer processing" CS MANTECH CONFERENCE, MAY 14-17, 2007, AUSTIN, TEXAS, USA,, 14. Mai 2007 (2007-05-14), Seiten 33-36, XP009135539 in der Anmeldung erwähnt

## Beschreibung

Die Erfindung betrifft ein Verfahren zum materialabtragenden Bearbeiten von flachen Werkstücken nach dem Oberbegriff des Anspruchs 1. Es besteht ein Bedürfnis, immer dünnere Werkstücke materialabtragend, insbesondere schleifend zu bearbeiten. Bei solchen Werkstücken kann es sich z.B. um Halbleiterscheiben (Wafer) handeln, die nach und gegebenenfalls bereits vor der Bearbeitung eine Dicke von weniger als 100 µm aufweisen können. Derartige Werkstücke sind so flexibel, dass eine Bearbeitung in normalen Schleifmaschinen nicht möglich ist. In C. Landesberger et al.: Carrier Techniques for Thin Wafer Processing, CS Mantech Conference, May 14-17, 2007, Austin, Texas, USA werden verschiedene Möglichkeiten zur Befestigung von sehr dünnen Wafern auf einem Träger beschrieben. So können die Wafer z.B. auf einen Träger aufgeklebt werden oder auf diesem mittels elektrostatischer Kräfte gehalten werden. Beschrieben ist auch das Verkleben der Wafer in einem dickeren Trägerrahmen. Durch die Verbindung der Wafer mit einem Träger soll eine Bearbeitung der Wafer möglich sein, ohne für die unterschiedlichen Bearbeitungsvorgänge zwischen verschiedenen Trägern wechseln zu müssen. Die Bearbeitung der auf den Trägern befestigten Werkstücke erfolgt, indem die Träger von einer Vakuumhalteeinrichtung gehalten werden und eine Schleifscheibe entlang einer Kreisbahn über die Oberfläche der Werkstücke geführt und auf die Werkstücke gedrückt wird. Nachteilig ist dabei, dass sich in der Mitte der bearbeiteten Werkstückoberfläche eine Unstetigkeitsstelle bildet.

Beispielsweise aus JP -S-62-264864 ist ein Verfahren zum materialabtragenden Bearbeiten von Wafern in einer Doppelseitenbearbeitungsmaschine mit Planetenkinematik bekannt. Dabei werden die zu bearbeitenden Wafer in Läuferscheiben aufgenommen und drehen sich entlang zykloidischer Bahnen zwischen den Arbeitsflächen. Für die Bearbeitung werden zwei Wafer durch einen Klebstoff miteinander verbunden, so dass jeweils eine Seite der Wafer bearbeitet wird. Darüber hinaus ist aus US 5 538 460 A eine Vorrichtung zum schleifenden Bearbeiten scheibenförmiger Substrate bekannt, die eine radial über die Oberflächen der Schleifscheiben bewegbare Abrichteinrichtung umfasst. Aus WO 99/16580 A1 ist ein Verfahren zur Einseitenbearbeitung von Wafern bekannt, bei dem Wafer beispielsweise durch ein Wachs an einer Haltescheibe fixiert werden und anschließend die freie Oberfläche der Wafer mittels einer Polierscheibe poliert wird.

Ausgehend von dem erläuterten Stand der Technik liegt der Erfindung die Aufgabe zugrunde, ein Verfahren der eingangs genannten Art bereitzustellen, mit dem in einfacher Weise eine präzisere materialabtragende Bearbeitung sehr dünner Werkstücke möglich ist.

Die Erfindung löst diese Aufgabe durch die Gegenstände des Anspruchs 1.

Vorteilhafte Ausgestaltungen finden sich in den abhängigen Ansprüchen, der Beschreibung und den Figuren.

Erfindungsgemäß findet also ein Bearbeiten der dünnen Werkstücke in einer Doppelseitenbearbeitungsmaschine mit Planetenkinematik statt. Dabei sind mehrere Läuferscheiben vorgesehen, die jeweils durchgehende Ausnehmungen aufweisen. Die Träger mit den daran befestigten Werkstücken werden in den Läuferscheiben gehalten und im Arbeitsspalt zwischen den Arbeitsflächen schwimmend geführt. Zumindest die den Werkstücken zugeordnete Arbeitsfläche der Maschine besitzt einen Arbeitsbelag, insbesondere einen Schleif- oder Polierbelag, und führt so zu einem Materialabtrag. Die Werkstücke können dabei so dünn sein, dass sie nach und gegebenenfalls auch schon vor der Bearbeitung so elastisch sind, dass sie in der Maschine ohne die Träger nicht bearbeitet werden können. Die Werkstücke können erfindungsgemäß bereits vor der Bearbeitung, und insbesondere nach der Bearbeitung, eine geringere Dicke aufweisen als die Träger. Die Träger stellen durch ihre größere Dicke dann die für die Bearbeitung in der Doppelseitenmaschine erforderliche Stabilität zur Verfügung. Erfindungsgemäß ist erkannt worden, dass auf diese Weise insbesondere eine schleifende Bearbeitung von sehr dünnen Werkstücken auch in einer Doppelseitenbearbeitungsmaschine mit Planetenkinematik erfolgen kann, wenn die Abtragsrate der Träger zumindest wesentlich geringer ist als die der Werkstücke. Durch die Planetenkinematik der Maschine, also die Ausbildung ihrer Läuferscheiben und deren Bewegung in dem Arbeitsspalt, wird ein besonders präziser und gleichmäßiger Materialabtrag gewährleistet. Unstetigkeitsstellen in der Mitte der Werkstücke werden sicher vermieden.

Um die Träger möglichst für mehrere zu bearbeitende Werkstücke wiederverwenden zu können, ist es vorteilhaft, wenn der Materialabtrag der Träger so gering wie möglich ist. Dazu werden die unterschiedlichen Abtragsraten der freien Oberflächen der Werkstücke einerseits und der freien Oberflächen der Träger andererseits erzeugt, indem die obere Arbeitsfläche und die untere Arbeitsfläche unterschiedliche Arbeitsbeläge aufweisen. Auf diese Weise werden die unterschiedlichen Abtragsraten zumindest bei ähnlichen Werkstoffen der Träger und Werkstücke automatisch erzeugt. Wenn die materialabtragende Bearbeitung eine schleifende Bearbeitung ist, ist es insbesondere vorteilhaft, wenn die den Oberflächen der Werkstücke zugeordnete Arbeitsfläche mit einem Schleifbelag versehen ist und die den Oberflächen der Träger zugeordnete Arbeitsfläche mit einem Polierbelag versehen ist und die Bearbeitung ohne ein abrasives Poliermittel erfolgt. Ein Materialabtrag der Träger kann auf diese Weise nahezu vollständig vermieden werden. Der Materialabtrag ist beim Polieren so gering, dass auch bei diesem Vorgehen die Träger mehrfach verwendet werden können.

Ein nicht erfindungsgemäßes Beispiel betrifft ein Verfahren zum materialabtragenden Bearbeiten, insbesondere zum schleifenden oder polierenden Bearbeiten, von flachen Werkstücken, die paarweise mit einer ihrer Oberflächen auf entsprechenden gegenüberliegenden Oberflächen von ebenfalls flachen Trägern lösbar befestigt sind, umfassend die Schritte:
- eine Doppelseitenbearbeitungsmaschine wird bereitgestellt, die eine obere Arbeitsscheibe mit einer oberen Arbeitsfläche und eine untere Arbeitsscheibe mit einer unteren Arbeitsfläche aufweist, wobei die Arbeitsflächen zwischen sich einen Arbeitsspalt bilden, in dem mindestens eine Läuferscheibe mit Ausnehmungen angeordnet ist,
- die Werkstücke werden gemeinsam mit den Trägern in den Ausnehmungen der mindestens einen Läuferscheibe angeordnet,
- mindestens eine der Arbeitsscheiben wird drehend angetrieben, wobei die mindestens eine Läuferscheibe mittels einer Abwälzvorrichtung ebenfalls in Rotation versetzt wird, wodurch sich die in der Läuferscheibe aufgenommenen Träger mit den Werkstücken entlang zykloidischer Bahnen zwischen den Arbeitsflächen bewegen, und wobei eine der Arbeitsflächen mit den jeweils freien Oberflächen der auf einer Seite der Träger befestigten Werkstücke und eine der Arbeitsflächen mit den jeweils freien Oberflächen der auf der gegenüberliegenden Seite der Träger befestigten Werkstücke in Kontakt kommt,
- die freien Oberflächen der an den gegenüberliegenden Seiten der Träger lösbar befestigten Werkstücke werden durch die ihnen zugeordnete Arbeitsfläche jeweils materialabtragend bearbeitet.

Während bei der erfindungsgemäßen Lösung auf einem Träger jeweils lediglich ein Werkstück lösbar befestigt wird, ist bei diesem nicht erfindungsgemäßen Beispiel vorgesehen, dass an jedem Träger zwei Werkstücke lösbar befestigt sind, insbesondere eines auf seiner Oberseite und eines auf seiner Unterseite. Ein solches "Dreifach-Stack" aus zwei Werkstücken und einem Träger kann ebenfalls mit der Doppelseitenbearbeitungsmaschine mit Planetenkinematik materialabtragend bearbeitet werden. Dabei können die paarweise an einem Träger befestigten Werkstücke durch die obere und die untere Arbeitsfläche der Doppelseitenmaschine, insbesondere mit derselben Abtragsrate bearbeitet werden. Die Träger kommen dabei nicht mit den Arbeitsflächen in Kontakt.

Die Werkstücke und die Träger können erfindungsgemäß jeweils zylindrisch ausgebildet sein. Die Oberflächen sind dabei die Ober- und Unterseiten der Werkstücke bzw. Träger. Sie können im Wesentlichen parallele Oberflächen, insbesondere planparallele Oberflächen besitzen. Vor der Bearbeitung können die Werkstücke auf ihrer Oberseite bereits integrierte Schaltungen aufweisen. Sie werden dann von ihrer Unterseite bearbeitet.

Die Werkstücke können erfindungsgemäß nach der Bearbeitung eine Dicke von weniger als 100 µm, bevorzugt weniger als 50 µm, weiter bevorzugt weniger als 20 µm, besitzen. Solche Werkstücke sind ohne die Träger in einer Doppelseitenbearbeitungsmaschine der erfindungsgemäßen Art nicht bearbeitbar. Die Träger können vor und/oder nach der Bearbeitung um ein Vielfaches dicker sein als die Werkstücke. Die Dicke der Träger kann beispielsweise vor und/oder nach der Bearbeitung in einem Bereich zwischen 0,5 mm bis 2 mm, bevorzugt 0,7 mm bis 1,0 mm, liegen.

Bei der erfindungsgemäßen schwimmenden Bearbeitung der Träger mit den Werkstücken in den Läuferscheiben kommt es bei zylindrischen und an ihren Rändern bündig miteinander abschließenden Trägern und Werkstücken zu einem wiederholten Kontakt zwischen den Läuferscheiben und den Rändern der Träger und Werkstücke und damit einer Krafteinwirkung auf die Träger und Werkstücke. Dies kann insbesondere bei den erfindungsgemäß dünnen Werkstücken zu Beschädigungen führen. Eine weitere Ausgestaltung sieht daher vor, dass die Träger und die Werkstücke eine im Wesentlichen zylindrische Form besitzen und die Träger einen größeren Durchmesser besitzen als die Werkstücke. Dabei können die Werkstücke beispielsweise koaxial auf den Trägern befestigt sein. Bei dieser Ausgestaltung kommen bei der Bearbeitung nur die Ränder der insbesondere dickeren Träger mit den Läuferscheiben in Kontakt, die die entsprechenden Kräfte ohne Beschädigungsgefahr aufnehmen können. Eine unerwünschte Krafteinwirkung auf die dünnen Werkstücke wird also sicher vermieden.

Die Werkstücke können durch eine Klebverbindung an den Trägern befestigt sein, beispielsweise durch ein Wachs, einen Klebstoff oder eine Klebfolie. Die Klebeverbindung kann thermisch, chemisch (z.B. durch ein Lösemittel), ätzend (z.B. durch ein Ätzmittel) oder durch UV-Bestrahlung lösbar sein. Beispielsweise bei einer thermischen Lösbarkeit muss gewährleistet sein, dass die im Rahmen der materialabtragenden Bearbeitung auftretenden Temperaturen niedriger sind als die Temperatur, bei der die Klebverbindung sich löst. Nach der Bearbeitung kann dann durch geeignete thermische Einwirkung die Klebverbindung gelöst und das Werkstück so von dem Träger entfernt werden. Ebenso kann auch vorgesehen sein, dass die Werkstücke durch elektrostatische Aufladung an dem Träger befestigt sind.

Bei den Werkstücken kann es sich um Halbleiterscheiben, z.B. Wafer, insbesondere Siliziumwafer, handeln. Bei den Trägern kann es sich ebenfalls um solche Halbleiterscheiben, z.B. Wafer, insbesondere Siliziumwafer, handeln. Diese sind kostengünstig verfügbar und als Träger gut geeignet. Die Träger und die Werkstücke können also aus demselben Material bestehen. Es ist jedoch auch möglich, dass die Träger aus einem Glaswerkstoff, einem Keramikwerkstoff oder einem Kunststoffwerkstoff bestehen. Durch eine andere Materialwahl für die Träger als für die Werkstücke kann beim ersten erfindungsgemäßen Verfahren eine andere Abtragsrate an den Trägern in besonders einfacher Weise erreicht werden.

Bei den erfindungsgemäß vor und insbesondere nach der Bearbeitung außerordentlich geringen Materialdicken der Werkstücke ist eine präzise Überwachung des Materialabtrags und damit der Werkstückdicke von entscheidender Bedeutung. Eine weitere Ausgestaltung sieht daher vor, dass die Dicke der Werkstücke während ihrer Bearbeitung mittels eines optischen Messverfahrens, insbesondere eines interferometrischen Messverfahrens, in der Bearbeitungsmaschine gemessen wird. Es kann z.B. Infrarot-Interferometrie eingesetzt werden, was insbesondere bei Werkstücken aus Silizium, welche für Infrarotstrahlung transparent sind, bevorzugt ist. Solche Messverfahren bieten eine besonders hohe Messgenauigkeit, wie sie bei der erfmdungsgemäßen Bearbeitung sehr dünner Werkstücke erforderlich ist. Erfindungsgemäß ist erkannt worden, dass solche Messverfahren in einer Doppelseitenbearbeitungsmaschine mit Planetenkinematik einsetzbar sind. Dabei wird die Dicke der Werkstücke noch in der Bearbeitungsmaschine gemessen, es wird also insbesondere eine optische Messeinrichtung in oder an der Bearbeitungsmaschine angeordnet. Es sind so Messgenauigkeiten von 1 µm und besser möglich. Verfälschende Einflüsse, wie Temperaturdrift, Werkzeugverschleiß, Verschmutzung und mechanische Nachgiebigkeit des Werkstücks, können dabei weitgehend ausgeschlossen werden. Im Vergleich zu taktilen Messverfahren findet darüber hinaus keinerlei Einwirkung auf die Werkstücke durch die Messung statt. Es ist auch möglich, nur die Dicke des Werkstücks getrennt von dem Träger zu bestimmen. Dies gilt insbesondere, wenn Träger und Werkstück aus unterschiedlichen Materialien bestehen und/oder eine geeignete optische Trennschicht zwischen den Werkstücken und dem Träger vorgesehen ist, z.B. eine Klebverbindung. Auch kann mit der optischen Messeinrichtung ein Dickenprofil erstellt und so die Gleichmäßigkeit der Bearbeitung überwacht werden.

Gemäß einer Fortbildung dieser Ausgestaltung des Verfahrens können entsprechend weiterhin die folgenden Schritte vorgesehen sein:
- Infrarotstrahlung wird auf die freie Oberfläche der Werkstücke gerichtet, wobei ein erster Strahlungsanteil an der freien Oberfläche reflektiert wird und ein zweiter Strahlungsanteil die Werkstückdicke durchdringt, an der mit dem Träger befestigten Werkstückoberfläche reflektiert wird und wieder an der freien Werkstückoberfläche austritt,
- der erste und der zweite Strahlungsanteil interferieren unter Bildung eines Interferenzmusters,
- anhand des Interferenzmusters wird die optische Werkstückdicke zwischen der freien Werkstückoberfläche und der mit dem Träger befestigten Werkstückoberfläche bestimmt,
- aus der optischen Werkstückdicke wird unter Berücksichtigung des Brechungsindexes des Werkstückmaterials die mechanische Werkstückdicke ermittelt.

Zur Überwachung der Werkstückdicke kommen aber grundsätzlich auch andere Messverfahren in Frage. So kann die Dicke der Werkstücke während ihrer Bearbeitung in der Bearbeitungsmaschine z.B. mittels mindestens eines Wirbelstromsensors oder mittels mindestens eines Ultraschallsensors oder mittels anderer Messverfahren gemessen werden, die eine ausreichende Messgenauigkeit besitzen, um Dicken im Bereich von weniger als 1 mm zu messen.

Bei ihrer zykloidischen Bahnbewegung können die Werkstücke einen Bereich außerhalb des Arbeitsspalts durchlaufen. Dieser wird fachsprachlich als Überlauf bezeichnet. Er befindet sich beispielsweise an der Außenseite des Arbeitsspalts. Bei einem ringförmigen Arbeitsspalt kann sich ein solcher Überlauf aber auch an der Innenseite des Arbeitsspalts befinden. Nach einer Ausgestaltung kann daher vorgesehen sein, dass die (beispielsweise optische) Dickenmessung in dem Bereich außerhalb des Arbeitsspalts erfolgt. Der Überlauf ist gut zugänglich und eignet sich daher besonders für eine Dickenmessung in diesem Bereich.

Nach einer alternativen Ausgestaltung kann jedoch auch vorgesehen sein, dass die Bearbeitungsmaschine mindestens eine in einer Arbeitsscheibe der Bearbeitungsmaschine angeordnete optische oder andere geeignete Messeinrichtung aufweist, mit der die Dickenmessung erfolgt. Dieser Ausgestaltung liegt die Idee zugrunde, eine Messeinrichtung in einer der Arbeitsscheiben, wegen möglicher Verschmutzungen bevorzugt in der oberen Arbeitsscheibe, anzuordnen und auf diese Weise eine Dickenmessung während der Bearbeitung zu ermöglichen.

Ein Ausführungsbeispiel der Erfindung wird nachfolgend anhand von Zeichnungen näher erläutert. Es zeigen schematisch:
- Fig. 1: eine bei dem erfindungsgemäßen Verfahren eingesetzte Doppelseiten-Schleifmaschine in einer perspektivischen Ansicht,
- Fig. 2: ein für die erfindungsgemäße Bearbeitung mit einem Träger verbundenes Werkstück in einer Schnittansicht,
- Fig. 3: eine vergrößerte Draufsicht auf die untere Arbeitsscheibe der Vorrichtung aus Fig. 1,
- Fig. 4: einen vergrößerten Ausschnitt der bei dem erfindungsgemäßen Verfahren eingesetzten Doppelseitenschleifmaschine in einer Schnittansicht, und
- Fig. 5: zwei für eine nicht erfindungsgemäße Bearbeitung mit einem Träger verbundene Werkstücke in einer Schnittansicht.

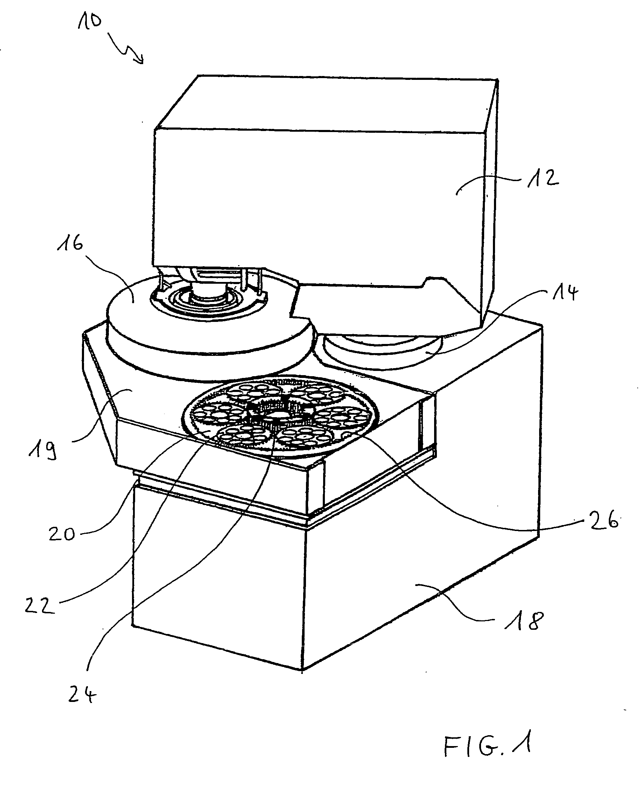

Sofern nichts anderes angegeben ist, bezeichnen in den Figuren gleiche Bezugszeichen gleiche Gegenstände. Fig. 1 zeigt schematisch den Aufbau einer erfindungsgemäß eingesetzten Doppelseitenbearbeitungsmaschine 10, in dem dargestellten Beispiel einer Doppelseitenschleifmaschine 10, mit Planetenkinematik. Die Doppelseitenschleifmaschine 10 weist einen oberen Schwenkarm 12 auf, der über eine am unteren Sockel 18 gelagerte Schwenkeinrichtung 14 um eine vertikale Achse geschwenkt werden kann. An dem Schwenkarm 12 wird eine obere Arbeitsscheibe 16 getragen. In dem dargestellten Beispiel ist die obere Arbeitsscheibe 16 über einen nicht näher dargestellten Antriebsmotor drehend antreibbar. An ihrer in Fig. 1 nicht dargestellten Unterseite besitzt die obere Arbeitsscheibe 16 eine Arbeitsfläche. Auf dieser ist in dem dargestellten Beispiel ein Polierbelag angeordnet. Der untere Sockel 18 weist einen Trägerabschnitt 19 auf, der eine untere Arbeitsscheibe 20 trägt, die an ihrer Oberseite eine der Arbeitsfläche der oberen Arbeitsscheibe 16 entsprechende Arbeitsfläche besitzt. Über den Schwenkarm 12 kann die obere Arbeitsscheibe 16 koaxial zu der unteren Arbeitsscheibe 20 ausgerichtet werden. Die untere Arbeitsscheibe 20 ist in dem dargestellten Beispiel ebenfalls über einen nicht dargestellten Antriebsmotor drehend antreibbar, insbesondere gegenläufig zu der oberen Scheibe 16. Selbstverständlich ist es auch möglich, nur eine der Arbeitsscheiben 16, 20 rotierend antreibbar auszubilden. Auf der Arbeitsfläche der unteren Arbeitsscheibe 20 ist in dem dargestellten Beispiel ein Schleifbelag angeordnet.

Auf der unteren Arbeitsscheibe 20 sind mehrere Läuferscheiben 22 dargestellt, die jeweils Ausnehmungen für zu bearbeitende Werkstücke gemeinsam mit den an ihnen befestigten Trägern aufweisen. Die Läuferscheiben 22 greifen jeweils mit einer Außenverzahnung in einen Innenstiftkranz 24 und einen Außenstiftkranz 26 ein. Auf diese Weise wird eine Abwälzvorrichtung gebildet, wobei die Läuferscheiben 22 bei einer Rotation der unteren Arbeitsscheibe 20 beispielsweise über den Innenstiftkranz 24 ebenfalls in Rotation versetzt werden. Die in den Ausnehmungen der Läuferscheiben 22 angeordneten Werkstücke und Träger bewegen sich dann auf der unteren Arbeitsscheibe 20 entlang zykloidischer Bahnen.

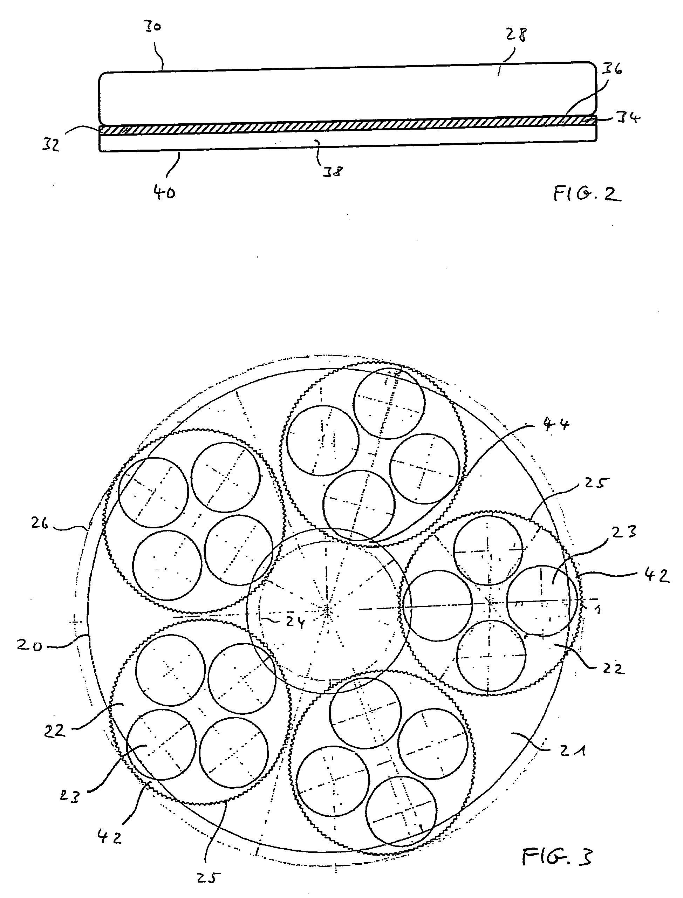

Die mit der in Fig. 1 dargestellten Doppelseitenschleifmaschine erfindungsgemäß zu bearbeitenden Werkstücke und Träger sind in Fig. 2 gezeigt. Die Werkstücke und Träger sind dabei zylindrisch ausgebildet. Es versteht sich, dass die Dicke der Werkstücke und Träger im Verhältnis zu ihrem Durchmesser stark übertrieben dargestellt ist. In Fig. 2 ist ein zylindrischer Träger 28, vorliegend ein Siliziumwafer, gezeigt. Der Träger 28 besitzt in dem dargestellten Beispiel eine Dicke von etwa 1 mm. Während die Oberseite 30 des Trägers 28 frei ist, ist die Unterseite 32 über eine Klebverbindung 34 mit der Oberseite 36 eines zu bearbeitenden Werkstücks 38, vorliegend ebenfalls eines Siliziumwafers, verbunden. Die Klebverbindung 34 kann z.B. durch ein Wachs, einen Klebstoff oder eine Klebefolie gebildet werden. Das Wachs, der Klebstoff bzw. die Klebefolie können z.B. thermisch, chemisch, ätzend oder durch UV-Bestrahlung lösbar sein. Die Unterseite 40 des Werkstücks 38 ist wiederum frei. In dem in Fig. 2 dargestellten Beispiel schließen Träger 28 und Werkstück 38 an ihren Außenseiten in dem an dem Träger 28 befestigten Zustand des Werkstücks 38 bündig miteinander ab. Es ist aber auch möglich, dass Träger 28 und Werkstück 38 unterschiedliche Durchmesser besitzen und nicht bündig miteinander abschließen. Das in Fig. 2 gezeigte Werkstück 38 besitzt in dem Beispiel eine Dicke von weniger als 100 µm nach der Bearbeitung. Es ist dadurch ohne den Träger 28 derart flexibel, dass es in der in Fig. 1 gezeigten Doppelseitenschleifmaschine 10 nicht bearbeitet werden könnte. Durch die Befestigung an dem erheblich dickeren Träger 28 wird jedoch eine Stabilität erreicht, die ausreichend für die Bearbeitung in der Maschine 10 ist.

Zur Bearbeitung werden die Werkstücke 38 gemeinsam mit den Trägern 28 in die Ausnehmungen der Läuferscheiben 22 eingelegt und schwimmend in dem zwischen den durch Verschwenken des Schwenkarms 12 koaxial zueinander ausgerichteten Arbeitsscheiben 16, 20 gebildeten Arbeitsspalt gelagert. Bei mindestens einer rotierenden oberen oder unteren Arbeitsscheibe 16, 20 wird anschließend beispielsweise die obere Arbeitsscheibe 16 mit einer Anpresskraft nach unten gedrückt. Dabei kommt es zu einem schleifenden Kontakt zwischen dem Schleifbelag der unteren Arbeitsscheibe 20 und der freien Unterseite 40 der Werkstücke 38. Gleichzeitig kommt der Polierbelag der oberen Arbeitsscheibe 16 mit der oberen freien Seite 30 der Träger 28 in Kontakt. Die schleifende Bearbeitung findet dabei lediglich mit Wasser als Kühlmedium statt. Ein Poliermittel mit einem Abrasivmaterial kommt nicht zum Einsatz. Dadurch können die Werkstücke 38 von ihrer Unterseite 40 dünn geschliffen werden, ohne dass ein Materialabtrag an der Oberseite 30 der Träger 28 eintritt. Nach der Bearbeitung wird die obere Arbeitsscheibe 16 wieder weggeschwenkt und die bearbeiteten Werkstücke 38 können gemeinsam mit den Trägern 28 aus den Läuferscheiben entnommen werden. Anschließend kann beispielsweise durch thermische Einwirkung die Klebverbindung 34 gelöst und die Werkstücke 38 so von den Trägern 28 getrennt werden. Die Träger 28 können anschließend wiederverwendet werden.

In Fig. 3 ist eine vergrößerte Draufsicht der unteren Arbeitsscheibe 20 mit ihrer Arbeitsfläche 21 mit dem Schleifbelag dargestellt. Weiter zu erkennen sind die Läuferscheiben 22 mit mehreren Ausnehmungen 23 für die Träger und Werkstücke. Ebenfalls zu erkennen ist der Innenstiftkranz 24 und der Außenstiftkranz 26, an dem sich die Läuferscheiben 22 mit ihrer Außenverzahnung 25 abwälzen. Im Zuge der zykloidischen Bahnbewegung durchlaufen die Ausnehmungen 23 und mit ihnen die darin aufgenommenen Träger 28 und Werkstücke 38 teilweise einen Bereich 42 außerhalb des durch die untere Arbeitsfläche 21 und die obere Arbeitsfläche der oberen Arbeitsscheibe 16 im Betrieb begrenzten Arbeitsspalts. Dieser Bereich 42 wird fachsprachlich als Überlauf 42 bezeichnet. Ein zweiter Bereich 44 außerhalb des durch die Arbeitsscheiben 16, 20 begrenzten ringförmigen Arbeitsspalts befindet sich in Fig. 3 an der Innenseite des Arbeitsspalts. Im Folgenden wird beispielhaft eine interferometrische Dickenmessung der in den Ausnehmungen 23 angeordneten Werkstücke 38 im Bereich des äußeren Überlaufs 42 beschrieben. Selbstverständlich wäre eine solche Dickenmessung in analoger Weise auch im Bereich des inneren Überlaufs 44 möglich. Ebenso könnte bei Anordnung einer geeigneten Messeinrichtung in einer der Arbeitsflächen der oberen oder unteren Arbeitsscheibe 16, 20 eine Messung auch innerhalb des Arbeitsspalts erfolgen. Auch ist es bei einer nicht erfindungsgemäßen Bearbeitung von Dreifach-Stacks möglich, Messeinrichtungen zur Dickenmessung an der Ober- und Unterseite der Stacks vorzusehen, um die Dicke beider Werkstücke zu messen.

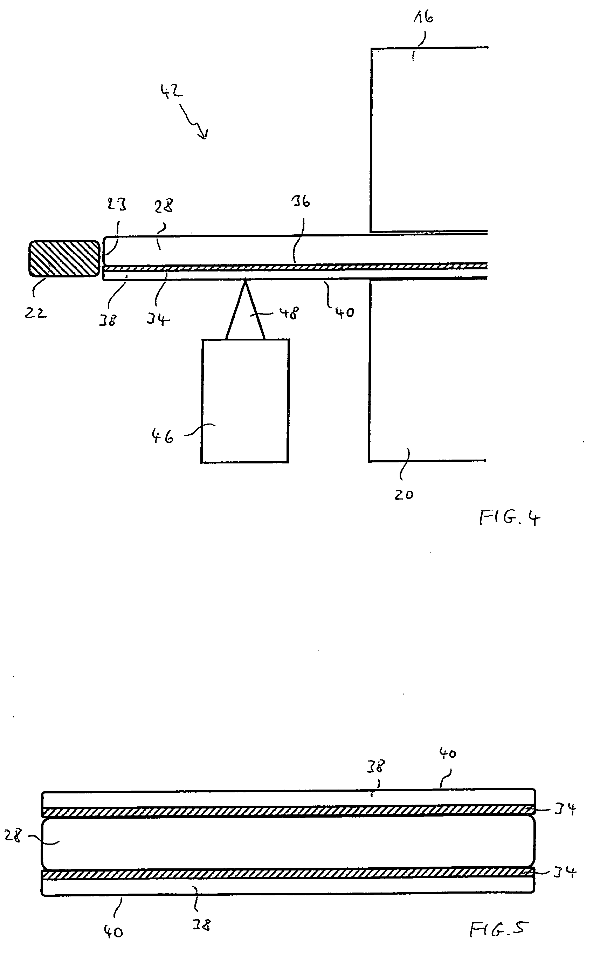

Wie in der Darstellung in Fig. 4 vergrößert und ausschnittsweise gezeigt, ist im Bereich des äußeren Überlaufs 42 eine optische Messeinrichtung 46 angeordnet. In dem dargestellten Beispiel handelt es sich bei der Messeinrichtung 46 um ein Infrarotinterferometer. In der Schnittansicht in Fig. 4 ist ein Werkstück 38 gemeinsam mit einem Träger 28 in einer teilweise zu erkennenden Läuferscheibe 22 dargestellt. Im Zuge seiner Bearbeitung in der Bearbeitungsmaschine 10 durchläuft dieses Werkstück 38 mit seinem Träger 28 zeitweise den Überlauf 42. In dem gezeigten Beispiel wird Infrarotstrahlung 48, vorliegend ein Infrarotstrahlungsspektrum 48, von unten auf die freie Unterseite 40 des Werkstücks 38 gerichtet. Die Infrarotstrahlung 48 wird mit einem ersten Strahlungsanteil an der freien Werkstückunterseite 40 reflektiert, während ein zweiter Strahlungsanteil das für Infrarotstrahlung hochtransparente Werkstück 38 durchdringt, an der mit dem Träger 28 verbundenen Oberseite 36 des Werkstücks 38 innen reflektiert wird und direkt oder nach mehreren Reflexionen an den Innenflächen des Werkstücks 38 wieder an der freien Unterseite 40 des Werkstücks 38 austritt. Die von dem Werkstück 38 in die Messvorrichtung 46 zurückkommenden ersten und zweiten Strahlungsanteile interferieren anschließend miteinander, was durch eine geeignete Sensoreinrichtung (nicht dargestellt) aufgenommen wird. Auf dieser Grundlage kann die mechanische Werkstückdicke aus der ermittelten optischen Werkstückdicke und dem bekannten Brechungsindex ermittelt werden.

Mit der Messeinrichtung 46 ist somit eine präzise Dickenmessung des Werkstücks 38 getrennt von dem Träger 28 möglich. Auf diese Weise kann das erfindungsgemäße Bearbeitungsverfahren noch präziser durchgeführt werden. Es ist auch möglich, z.B. den in dem Überlauf 42 befindlichen Teil des Werkstücks 38 radial zu vermessen und ein entsprechendes Dickenprofil zu erstellen, um so die Bearbeitungsgenauigkeit weiter zu erhöhen.

In Fig. 5 ist eine nicht erfindungsgemäße Anordnung gezeigt, die weitgehend der Anordnung aus Fig. 2 entspricht. Im Unterschied zu Fig. 2 sind hier allerdings auf einem Träger 28 auf seinen gegenüberliegenden oberen und unteren Oberflächen jeweils ein Werkstück 38 über die Klebeverbindung 34 lösbar befestigt. Es handelt sich also um einen sogenannten Dreifach-Stack. Diese Anordnung kann ebenfalls in der beispielsweise in Fig 1 gezeigten Vorrichtung bearbeitet werden. Dabei kann insbesondere dieselbe Abtragsrate für das obere und das untere Werkstück vorgesehen sein, da in diesem Fall der Träger nicht in Kontakt mit den Arbeitsflächen kommt.

Das erfindungsgemäße Verfahren ermöglicht eine hochpräzise Bearbeitung sehr dünner Werkstücke, die nach der Bearbeitung eine Dicke im Bereich von weniger als 100 µm, bevorzugt weniger als 50 µm, weiter bevorzugt weniger als 20 µm, beispielsweise im Bereich von ca. 10 µm, aufweisen können. Gleichzeitig können die Werkstücke 38 aufgrund ihrer Verbindung mit dem Träger 28 im Rahmen ihres gesamten Bearbeitungsprozesses, beispielsweise auch einem anschließenden Polieren, problemlos mit denselben Werkzeugen transportiert werden.

## Patentansprüche

1. Verfahren zum materialabtragenden Bearbeiten, insbesondere zum schleifenden oder polierenden Bearbeiten, von flachen Werkstücken (38), die mit einer ihrer Oberflächen jeweils auf einer entsprechenden Oberfläche von ebenfalls flachen Trägern (28) lösbar befestigt sind, wobei das Verfahren folgende Schritte aufweist :
- eine Doppelseitenbearbeitungsmaschine (10) wird bereitgestellt, die eine obere Arbeitsscheibe (16) mit einer oberen Arbeitsfläche und eine untere Arbeitsscheibe (20) mit einer unteren Arbeitsfläche aufweist, wobei die Arbeitsflächen zwischen sich einen Arbeitsspalt bilden, in dem mindestens eine Läuferscheibe (22) mit Ausnehmungen (23) angeordnet ist,
- die Werkstücke (38) werden gemeinsam mit den Trägern (28) in den Ausnehmungen (23) der mindestens einen Läuferscheibe (22) angeordnet,
- mindestens eine der Arbeitsscheiben (16, 20) wird drehend angetrieben, wobei die mindestens eine Läuferscheibe (22) mittels einer Abwälzvorrichtung ebenfalls in Rotation versetzt wird, wodurch sich die in der Läuferscheibe (22) aufgenommenen Träger (28) mit den Werkstücken (38) entlang zykloidischer Bahnen zwischen den Arbeitsflächen bewegen, und wobei eine der Arbeitsflächen mit den jeweils freien Oberflächen der Träger (28) und eine der Arbeitsflächen mit den jeweils freien Oberflächen der Werkstücke (38) in Kontakt kommt,
wobei das Verfahren **dadurch gekennzeichnet ist, dass**
- die freien Oberflächen der Werkstücke (38) durch die ihnen zugeordnete Arbeitsfläche materialabtragend bearbeitet werden, während durch die den freien Oberflächen der Träger (28) zugeordnete Arbeitsfläche entweder kein Materialabtrag erfolgt, oder eine Abtragsrate der freien Oberflächen der Träger (28) wesentlich kleiner ist als eine Abtragsrate der freien Oberflächen der Werkstücke (38), wobei die unterschiedlichen Abtragsraten der freien Oberflächen der Träger (28) einerseits und der freien Oberflächen der Werkstücke (38) andererseits erzeugt werden, indem die obere Arbeitsfläche und die untere Arbeitsfläche unterschiedliche Arbeitsbeläge aufweisen.

2. Verfahren nach Anspruch 1, **dadurch gekennzeichnet, dass** die materialabtragende Bearbeitung eine schleifende Bearbeitung ist, wobei die den Oberflächen der Werkstücke (38) zugeordnete Arbeitsfläche mit einem Schleifbelag versehen ist, und wobei die den Oberflächen der Träger (28) zugeordnete Arbeitsfläche mit einem Polierbelag versehen ist.

3. Verfahren nach Anspruch 2, **dadurch gekennzeichnet, dass** die Bearbeitung mit dem Polierbelag ohne ein Poliermittel erfolgt.

4. Verfahren nach einem der vorhergehenden Ansprüche, **dadurch gekennzeichnet, dass** die Werkstücke (38) bereits vor der Bearbeitung eine geringere Dicke aufweisen als die Träger (28).

5. Verfahren nach einem der vorhergehenden Ansprüche, **dadurch gekennzeichnet, dass** die Werkstücke (38) nach der Bearbeitung eine Dicke von weniger als 100µm, bevorzugt weniger als 50µm, weiter bevorzugt weniger als 20µm, besitzen.

6. Verfahren nach einem der vorhergehenden Ansprüche, **dadurch gekennzeichnet, dass** die Träger (28) eine Dicke im Bereich von 0,5mm bis 2mm, bevorzugt im Bereich von 0,7mm bis 1,0mm besitzen.

7. Verfahren nach einem der vorhergehenden Ansprüche, **dadurch gekennzeichnet, dass** die Träger (38) und die Werkstücke (28) eine zylindrische Form besitzen und die Träger (38) einen größeren Durchmesser besitzen als die Werkstücke (28).

8. Verfahren nach einem der vorhergehenden Ansprüche, **dadurch gekennzeichnet, dass** die Werkstücke (38) durch eine Klebeverbindung (34) an den Trägern (28) befestigt sind, insbesondere durch ein Wachs, einen Klebstoff oder eine Klebfolie, oder dass die Werkstücke (38) durch elektrostatische Aufladung an den Trägern (28) befestigt sind.

9. Verfahren nach Anspruch 8, **dadurch gekennzeichnet, dass** die Klebeverbindung thermisch, chemisch, ätzend oder durch UV-Bestrahlung lösbar ist.

10. Verfahren nach einem der vorhergehenden Ansprüche, **dadurch gekennzeichnet, dass** das Werkstück (38) eine Halbleiterscheibe ist.

11. Verfahren nach einem der vorhergehenden Ansprüche, **dadurch gekennzeichnet, dass** der Träger (28) eine Halbleiterscheibe ist, oder dass der Träger (28) aus einem Glaswerkstoff, einem Keramikwerkstoff oder einem Kunststoffwerkstoff besteht.

12. Verfahren nach einem der vorhergehenden Ansprüche, **dadurch gekennzeichnet, dass** mittels eines optischen Messverfahrens, insbesondere eines interferometrischen Messverfahrens, die Dicke der Werkstücke (38) während ihrer Bearbeitung in der Bearbeitungsmaschine gemessen wird.

13. Verfahren nach einem der Ansprüche 1 bis 11, **dadurch gekennzeichnet, dass** mittels mindestens eines Wirbelstromsensors oder mittels mindestens eines Ultraschallsensors die Dicke der Werkstücke (38) während ihrer Bearbeitung in der Bearbeitungsmaschine gemessen wird.

## Claims

1. A method for the material-removing machining, in particular for grinding or polishing machining, of flat work pieces (38), which are releasably fastened with one of their surfaces respectively on a corresponding surface of likewise flat supports (28),
wherein the method has the following steps:
- a double side machine tool (10) is provided, which has an upper work disk (16) with an upper work surface and a lower work disk (20) with a lower work surface, wherein the work surfaces amongst themselves form a work gap, in which at least one rotor disk (22) with recesses (23) is arranged,
- the work pieces (38) are arranged together with the supports (28) in the recesses (23) of the at least one rotor disk (22),
- at least one of the work disks (16, 20) is driven in a rotating manner, wherein the at least one rotor disk (22) is also rotated by a rolling device, whereby the supports (28) received in the rotor disk (22) move along cycloidal tracks between the work surfaces with the work pieces (38) and wherein one of the work surfaces comes in contact with the respectively free surfaces of the supports (28) and one of the work surfaces with the respectively free surfaces of the work pieces (38),
wherein the method is **characterized in that**
- the free surfaces of the work pieces (38) are machined in a material-removing manner by the work surface associated with them,
while through the work surface associated with the free surfaces of the supports (28), either no material removal takes place or a removal rate of the free surfaces of the supports (28) is considerably smaller than a removal rate of the free surfaces of the work pieces (38), wherein the different removal rates of the free surfaces of the support (28) are generated on one hand and of the free surfaces of the work pieces (38) on the other hand, **in that** the upper work surface and the lower work surface have different work layers.

2. The method according to claim 1, **characterized in that** the material-removing machining is a grinding machining, wherein the work surface associated with the surfaces of the work pieces (38) is provided with a grinding layer, and wherein the work surface associated with the surfaces of the supports (28) is provided with a polishing layer.

3. The method according to claim 2, **characterized in that** the processing with the polishing layer takes place without a polishing agent.

4. The method according to one of the previous claims, **characterized in that** the work pieces (38) already have a smaller thickness than the supports (28) before the machining.

5. The method according to one of the previous claims, **characterized in that** the work pieces (38) after machining have a thickness of less than 100 µm, preferably less than 50 µm, more preferably less than 20 µm.

6. The method according to one of the previous claims, **characterized in that** the supports (28) have a thickness in the range of 0.5 mm to 2 mm, preferably in the range of 0.7 mm to 1.0 mm.

7. The method according to one of the previous claims, **characterized in that** the supports (28) and the work pieces (38) have a cylindrical shape and the supports (28) have a larger diameter than the work pieces (38).

8. The method according to one of the previous claims, **characterized in that** the work pieces (38) are fastened to the supports (28) by an adhesive connection (34), in particular by a wax, an adhesive or an adhesive film, or **in that** the work pieces (38) are fastened to the supports (28) through electrostatic charging.

9. The method according to claim 8, **characterized in that** the adhesive connection can be detached thermally, chemically, corrosively or through UV radiation.

10. The method according to one of the previous claims, **characterized in that** the work piece (38) is a semi-conductor disk.

11. The method according to one of the previous claims, **characterized in that** the support (28) is a semi-conductor disk or **in that** the support (28) is made of a glass material, a ceramic material or a plastic material.

12. The method according to one of the previous claims, **characterized in that** the thickness of the work pieces (38) is measured during their machining in the machine tool by means of an optical measurement process, in particular an interferometric measurement process.

13. The method according to one of claims 1 to 11, **characterized in that** the thickness of the work pieces (38) is measured during their machining in the machine tool by means of at least one turbulent flow sensor or by means of at least one ultrasound sensor.

## Revendications

1. Procédé d'usinage par enlèvement de matière, notamment d'usinage par meulage ou polissage, de pièces plates (38) qui sont fixées de manière amovible avec une de leurs surfaces à chaque fois sur une surface correspondante de supports également plats (28),
dans lequel le procédé présente les étapes suivantes :
- une machine à usinage double face (10) est mise à disposition, laquelle présente un disque de travail supérieur (16) avec une face de travail supérieure et un disque de travail inférieur (20) avec une face de travail inférieure, dans lequel les faces de travail forment entre elles une fente de travail dans laquelle au moins un disque de rotor (22) avec des évidements (23) est disposé,
- les pièces (38) sont disposées ensemble avec les supports (28) dans les évidements (23) de l'au moins un disque de rotor (22),
- au moins un des disques de travail (16, 20) est entraîné à rotation, dans lequel l'au moins un disque de rotor (22) est également déplacé en rotation au moyen d'un dispositif à levier roulant, moyennant quoi les supports (28) reçus dans le disque de rotor (22) se déplacent avec les pièces (38) le long de voies cycloïdales entre les faces de travail, et dans lequel une des faces de travail vient en contact avec les surfaces à chaque fois libres des supports (28) et une des faces de travail vient en contact avec les surfaces à chaque fois libres des pièces (38),
dans lequel le procédé est **caractérisé en ce que**
- les surfaces libres des pièces (38) sont usinées par enlèvement de matière par la face de travail qui leur est associée tandis que soit aucun enlèvement de matière n'a lieu par la face de travail associée aux surfaces libres des supports (28), soit un débit d'enlèvement des surfaces libres des supports (28) est essentiellement inférieur à un débit d'enlèvement des surfaces libres des pièces (38), dans lequel les différents débits d'enlèvement des surfaces libres des supports (28) d'une part et des surfaces libres des pièces (38) d'autre part sont générés **en ce que** la face de travail supérieure et la face de travail inférieure présentent différentes couches de travail.

2. Procédé selon la revendication 1, **caractérisé en ce que** l'usinage par enlèvement de matière est un usinage par meulage, dans lequel la face de travail associée aux surfaces des pièces (38) est pourvue d'une couche de meulage, et dans lequel la face de travail associée aux surfaces des supports (28) est pourvue d'une couche de polissage.

3. Procédé selon la revendication 2, **caractérisé en ce que** l'usinage s'effectue avec une couche de polissage sans moyen de polissage.

4. Procédé selon une des revendications précédentes, **caractérisé en ce que** les pièces (38) présentent déjà avant l'usinage une épaisseur inférieure aux supports (28).

5. Procédé selon une des revendications précédentes, **caractérisé en ce que** les pièces (38) possèdent après l'usinage une épaisseur inférieure à 100 µm, de préférence inférieure à 50 µm, de manière davantage préférée inférieure à 20 µm.

6. Procédé selon une des revendications précédentes, **caractérisé en ce que** les supports (28) possèdent une épaisseur dans la région de 0,5 mm à 2 mm, de préférence dans la région de 0,7 mm à 1,0 mm.

7. Procédé selon une des revendications précédentes, **caractérisé en ce que** les supports (28) et les pièces (38) possèdent une forme cylindrique, et les supports (28) possèdent un diamètre supérieur aux pièces (38).

8. Procédé selon une des revendications précédentes, **caractérisé en ce que** les pièces (38) sont fixées aux supports (28) par un assemblage collé (34), notamment par une cire, un adhésif ou un film adhésif, ou que les pièces (38) sont fixées aux supports (28) par charge électrostatique.

9. Procédé selon la revendication 8, **caractérisé en ce que** l'assemblage collé peut être détaché par voie thermique, chimique, caustique ou par irradiation UV.

10. Procédé selon une des revendications précédentes, **caractérisé en ce que** la pièce (38) est une tranche de semi-conducteur.

11. Procédé selon une des revendications précédentes, **caractérisé en ce que** le support (28) est une tranche de semi-conducteur ou que le support (28) se compose d'un matériau de verre, d'un matériau céramique ou d'un matériau plastique.

12. Procédé selon une des revendications précédentes, **caractérisé en ce que** l'épaisseur des pièces (38) pendant leur usinage est mesurée dans la machine à usinage au moyen d'un procédé de mesure optique, notamment d'un procédé de mesure interférométuque.

13. Procédé selon une des revendications 1 à 11, **caractérisé en ce que** l'épaisseur des pièces (38) pendant leur usinage est mesurée dans la machine à usinage au moyen d'au moins un capteur de courant parasite ou au moyen d'au moins un capteur à ultrasons.
